# DEMANDE DE BREVET EUROPEEN

(11) **EP 2 182 096 A1**
(43) Date de publication de la demande: **05.05.2010**
(21) Numéro de dépôt: 08167767.6
(22) Date de dépôt: 28.10.2008
(51) Int. Cl.: C25D 1/00

(54) **Procédé LIGA hétérogène**

(71) Demandeur: Nivarox-FAR S.A., CH-2400 Le Locle (CH)
(72) Inventeur: Rey-Mermet, Gilles, 1870 Monthey (CH)
(74) Mandataire: Rossand, Isabelle

(57) **Abrégé**

Le procédé de fabrication de micro-pièces bimétals comprend les étapes consistant à :
a) se munir d'un substrat (1, 2) comportant une surface conductrice d'amorçage (2) ;
b) recouvrir la surface conductrice d'amorçage (2) d'une première couche de résine photosensible (3) ;
c) irradier la première couche de résine photosensible (3) à travers un masque (4) correspondant à l'empreinte désirée ;
d) développer la première couche de résine photosensible (3) de manière à creuser dans celle-ci des ouvertures et à obtenir ainsi un premier moule en résine (3b), les ouvertures dans le premier moule de résine laissant apparaître la surface conductrice d'amorçage (2) du substrat ;
e) électroformer le premier élément (5) par dépôt galvanique d'un premier métal dans les ouvertures du premier moule (3b) en résine ;
f) exposer la surface conductrice d'amorçage (2) du substrat en éliminant la résine photosensible constituant le premier moule (3b) autour du premier élément (5) ou, alternativement, déposer une fine couche de métal sur la première couche en résine photosensible de manière à former une nouvelle surface conductrice d'amorçage ;
g) recouvrir la surface conductrice d'amorçage (2) exposée, ainsi que le premier élément (5), d'une nouvelle couche de résine photosensible (7) ;
h) irradier la nouvelle couche de résine photosensible (7) à travers un masque (8) correspondant à l'empreinte désirée ;
i) développer la nouvelle couche de résine photosensible (7) de manière à creuser dans celle-ci des ouvertures et à obtenir ainsi un nouveau moule (7b) en résine, les ouvertures dans le nouveau moule de résine laissant apparaître le premier élément (5), ainsi que la surface conductrice d'amorçage (2) du substrat ou la nouvelle surface conductrice d'amorçage.
j) électroformer le deuxième élément (10) par dépôt galvanique d'un deuxième métal dans les ouvertures du nouveau moule (7b) en résine ;
k) séparer le premier (5) et le deuxième élément (10) du substrat (1).

## Description

### Domaine de l'invention

La présente invention concerne un procédé de fabrication de pièces métalliques par photolithographie UV et dépôt galvanique. La présente invention concerne plus particulièrement un tel procédé pour la fabrication de pièces comprenant au moins un premier élément réalisé en un premier métal inséré dans un deuxième élément réalisé en un deuxième métal.

### Arrière plan de l'invention

Parmi les procédés de fabrication de pièces métalliques par photolithographie UV et dépôt galvanique, les plus connus sont ceux basés sur la technologie LIGA-UV. A l'origine, la technologie LIGA (Lithographie Galvanik Abformung) a été développée par W. Ehrfeld du Karlsruhe Kernforschungszentrum, Allemagne) dans les années 80. Elle s'est révélée intéressante pour la fabrication de microstructures métalliques de hautes précisions.

Dans son principe la technique LIGA consiste à déposer sur un substrat conducteur ou revêtu d'une couche conductrice, une couche d'une résine photosensible, à effectuer à travers un masque correspondant au contour de la microstructure désirée une irradiation X au moyen d'un synchrotron; à développer, c'est-à-dire à éliminer par des moyens physiques ou chimiques les portions de la couche de résine photosensible non irradiées afin de définir un moule ayant le contour de la microstructure, à déposer électro-galvaniquement un métal typiquement du nickel dans le moule en résine photosensible, puis à éliminer le moule pour libérer la microstructure.

La qualité des microstructures obtenues ne prête pas à critique, mais la nécessité de mettre en oeuvre un équipement coûteux (synchrotron) rend cette technique peu compatible avec une production de masse de microstructures devant avoir un faible coût unitaire.

C'est pourquoi sur la base de ce procédé LIGA ont été développés des procédés analogues mais utilisant des résines photosensibles au rayonnement ultraviolet (UV). Un tel procédé est par exemple décrit dans la publication de A.B. Frazier et al., intitulée « Metallic Microstructures Fabricated Using Photosensitive Polyimide Electroplating Molds", Journal of Microelectromechanical systems, Vol. 2, N deg. 2, June 1993. Cet article décrit un procédé pour la fabrication de structures métalliques par électrodéposition de métal dans des moules en résine photosensible à base de polyimide. Ce procédé comprend les étapes suivantes :
- créer sur substrat une couche métallique sacrificielle et une couche d'amorçage pour une étape ultérieure de dépôt galvanique,
- appliquer une couche de polyimide photosensible,
- irradier à l'aide d'ultraviolets la couche de polyimide à travers un masque correspondant au contour de la microstructure désirée,
- développer en dissolvant les parties non irradiées de la couche de polyimide de façon à obtenir un moule en polyimide,
- déposer électro-galvaniquement du nickel dans la partie ouverte du moule jusqu'à la hauteur de celui-ci, et
- éliminer la couche sacrificielle et séparer la structure métallique obtenue du substrat et
- éliminer le moule en polyimide.

Les microstructures obtenues selon les procédés de l'art antérieur sont des microstructures métalliques réalisées en un seul métal, ce qui n'est pas toujours optimal, pour des applications horlogères notamment. En effet, il peut être intéressant, pour des raison esthétiques, tribologiques ou plus généralement mécaniques, etc., de réaliser des microstructures bimétals comportant au moins une pièce en un premier métal insérée dans une pièce en un deuxième métal.

Habituellement, pour réaliser de telles microstructures bimétals, l'insert (ou les inserts) en un premier métal est (ou sont) rapporté(s) de manière artisanale sur la pièce en un deuxième métal par enchâssement, sertissage, vissage ou autre emboutissage.

Le document de brevet EP 1'916'567 décrit un procédé de fabrication mixte de pièces par photolithographie, ajouts d'inserts et électroformage. Ce procédé nécessite l'assemblage d'au moins deux éléments, l'un obtenu par photolithographie et croissance galvanique, et l'autre par un autre procédé de fabrication, et il comprend les étapes suivantes :
- irradiation à travers un masque d'une couche de résine photosensible appliquée sur un substrat ;
- développement de la couche de résine photosensible pour former un moule en résine polymérisée ;
- placement d'un élément rapporté obtenu par un autre procédé de fabrication dans le moule de résine polymérisée ;
- dépôt galvanique d'une couche métallique à partir du fond du moule en résine de sorte que la couche métallique enserre tout ou partie de l'élément rapporté ;
- obtention de la pièce par séparation du substrat d'avec la couche métallique enserrant l'élément rapporté et élimination du moule en résine polymérisée.

On comprendra qu'au terme du procédé ci-dessus, l'élément rapporté est déjà inséré dans la pièce réalisée. Ainsi les opérations subséquentes d'enchâssement, de sertissage, de vissage ou autre emboutissage, peuvent être supprimées.

Le procédé qui vient d'être décrit présente quelques inconvénients. En effet, l'insert étant constitué par un élément rapporté venu d'ailleurs, il est nécessaire de venir le placer dans le moule en résine en faisant preuve d'une grande précision. Selon le document antérieur susmentionné, le positionnement précis de l'élément rapporté est assuré grâce à une configuration particulière du moule en résine polymérisée. En effet, selon ce document, la couche en résine est configurée de manière à ce que certaines portions de celle-ci puissent servir de guide pour l'élément rapporté. On comprendra qu'une telle manière de procéder limite considérablement le choix de la forme de la microstructure réalisée.

Un but de la présente invention est donc de fournir un procédé permettant la fabrication de pièces bimétals comprenant au moins un premier élément réalisé en un premier métal inséré dans un deuxième élément réalisé en un deuxième métal ; ce procédé autorisant une précision micrométrique dans le positionnement de l'insert, tout en accordant la plus grande liberté possible quant au choix de la forme de la microstructure.

### Résumé de l'invention

A cet effet, la présente invention a pour objet un procédé de fabrication de pièces métalliques par photolithographie UV et dépôt galvanique, **caractérisé en ce qu**'il comprend les étapes consistant à :
a) se munir d'un substrat comportant une surface conductrice ;
b) recouvrir la surface conductrice d'une première couche de résine photosensible ;
c) irradier la première couche de résine photosensible à travers un masque correspondant à l'empreinte désirée ;
d) développer la première couche de résine photosensible de manière à former dans celle-ci des ouvertures et à obtenir ainsi un premier moule en résine, les ouvertures dans le premier moule de résine laissant apparaître la surface conductrice du substrat ;
e) électroformer le premier élément par dépôt galvanique d'un premier métal dans les ouvertures du premier moule en résine ;
f) exposer la surface conductrice du substrat en éliminant la résine photosensible constituant le premier moule ou, alternativement, déposer une fine couche de métal sur la première couche en résine photosensible de manière à former une nouvelle surface conductrice ;
g) recouvrir les surfaces conductrices exposées et le premier élément d'une nouvelle couche de résine photosensible ;
h) irradier la nouvelle couche de résine photosensible à travers un masque correspondant à l'empreinte désirée ;
i) développer la nouvelle couche de résine photosensible de manière à creuser dans celle-ci des ouvertures et à obtenir ainsi un nouveau moule en résine, les ouvertures dans le nouveau moule de résine laissant apparaître le premier élément ainsi que la surface conductrice du substrat ou la nouvelle surface conductrice.
j) électroformer le deuxième élément par dépôt galvanique d'un deuxième métal dans les ouvertures du nouveau moule en résine ;
k) démouler le deuxième élément par séparation du substrat et élimination de la résine photosensible constituant le nouveau moule.

On comprendra qu'avec le procédé de la présente invention, l'insert est réalisé avec la même technologie que le reste de la pièce. Ainsi, un premier avantage de ce procédé réside dans le fait que le positionnement de l'insert en un premier métal (autrement dit le positionnement du premier élément) relativement au deuxième élément peut être réalisé avec toute la précision micrométrique propre à la technique LIGA.

### Brève description des dessins

D'autres caractéristiques et avantages du procédé selon la présente invention apparaîtront à la lecture de la description qui va suivre, donnée uniquement à titre d'exemple non limitatif, et faite en référence aux dessins annexés dans lesquels :

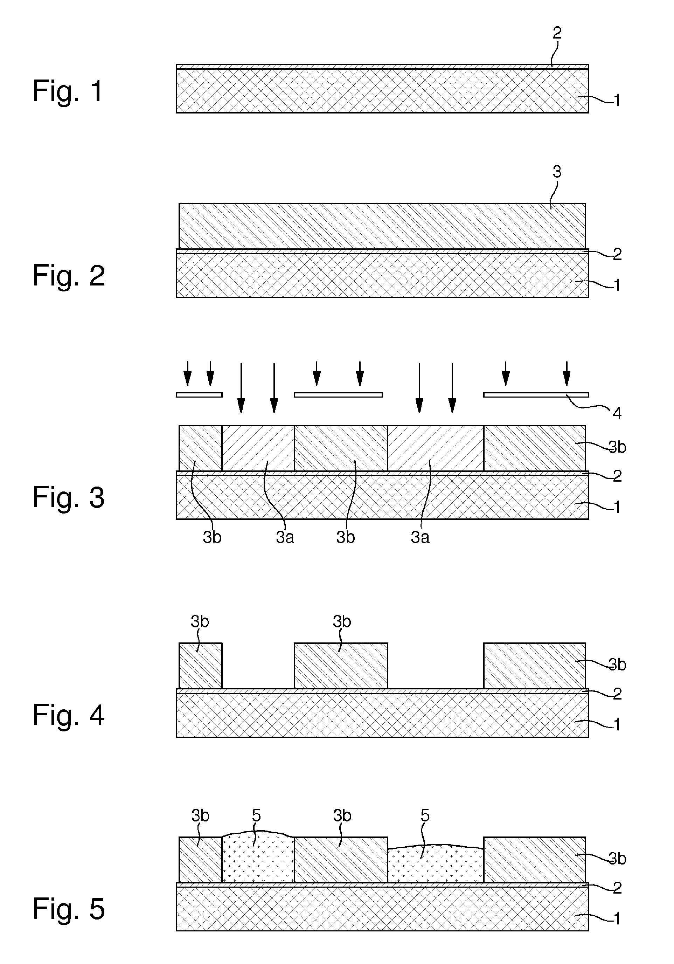

- les figures 1 à 12 illustrent différentes étapes de procédé correspondant à un mode particulier de mise en oeuvre du procédé de l'invention.

### Description détaillée de l'invention

Selon la présente invention, le procédé comporte l'étape de se munir d'un substrat comportant une surface conductrice. Dans le mode d'implémentation particulier illustré dans les figures, le substrat 1 est constitué par une plaquette de silicium, de verre ou de céramique sur laquelle on a préalablement déposé par évaporation une couche conductrice 2 (figure 1). Cette couche conductrice 2 est prévue pour servir de couche d'amorçage, c'est-à-dire de cathode, lors d'un dépôt galvanique ultérieur. Typiquement, la couche d'amorçage 2 peut être formée d'une sous couche de chrome ou de titane recouverte d'une couche d'or ou de cuivre.

Selon une variante non représentée, de manière à faciliter la séparation ultérieure de la pièce réalisée d'avec le substrat, on commence par déposer sur le substrat une couche présentant un faible degré de cohésion ou d'adhérence avec les autres couches. Cette couche, appelée couche sacrificielle, est prévue pour se rompre facilement, de manière à permettre de séparer la structure métallique multi niveau du substrat à la fin du procédé. La couche sacrificielle peut par exemple être réalisée en aluminium par vaporisation sous vide. L'épaisseur de la couche peut être de l'ordre d'un dixième de micron. Selon encore une autre variante, une même couche de métallisation peut remplir à la fois la fonction de couche sacrificielle et celle de couche d'amorçage. D'autre part, au lieu d'utiliser la vaporisation sous vide pour former une couche sacrificielle, il est également possible de former une telle couche par dépôt galvanique sur une première couche d'amorçage.

Alternativement, le substrat peut être formé par une plaque en acier inoxydable ou en un autre métal. On comprendra que dans ces conditions, il n'est pas nécessaire de déposer une couche conductrice. Toutefois, la surface d'amorçage devra en général être dégraissée avant usage.

L'étape suivante (figure 2) consiste à recouvrir la surface conductrice du substrat d'une première couche de résine photosensible 3. Dans le présent exemple, la résine utilisée pour cette première couche est un photoresist positif standard comme le Shipley S1818 ou le TOK C-1 000. Ce type de résine photosensible permet de préparer des couches aptes à être structurées par photolithographie. Ces couches ont des épaisseurs typiquement comprises entre 2 et 5 microns, et pouvant même aller jusqu'à une vingtaine de microns dans le cas du C-1 000.

Alternativement, on pourrait choisir comme résine photosensible le SU-8 disponible chez MicroChem Corporation. Cette résine constitue un photoresist négatif conçu pour polymériser sous l'action d'un rayonnement UV. L'avantage du SU-8 est qu'il permet de réaliser des couches aptes à être structurées par photolithographie qui sont considérablement plus épaisses. L'inconvénient du SU-8 est qu'il est plus difficile à éliminer lors du démoulage des éléments métalliques obtenus par croissance galvanique. On choisira donc plutôt une résine photosensible positive lorsque l'épaisseur des inserts que l'on désire réaliser ne dépasse pas quelques microns. Quoi qu'il en soit, on comprendra que la présente invention ne se limite pas à quelques types particuliers de résine photosensible. L'homme du métier saura choisir une résine photosensible convenant à ses besoins parmi toutes les résines connues qui sont adaptées à la photolithographie par UV.

La résine 3 peut être déposée sur la couche d'amorçage 2 à l'aide de toute technique connue de l'homme du métier ; par exemple, à la tournette (spin coating), par application au cylindre, ou encore par laminage lorsqu'il s'agit d'une résine en film, etc. Selon l'épaisseur et la technique utilisée, la résine pourra être déposée en une ou plusieurs fois.

Conformément au mode particulier de mise en oeuvre de l'invention qui fait l'objet de la présente description, après l'étape b) la couche de résine 3 est encore chauffée entre 90 et 95° C pendant une durée suffisante pour évaporer les solvants (pre-bake). L'homme du métier comprendra toutefois que selon la nature de la résine utilisée, cette étape de chauffage n'est pas forcément nécessaire.

L'étape suivante du procédé (figure 3) consiste à irradier la couche de résine au moyen d'un rayonnement UV à travers les ouvertures d'un masque 4 définissant le contour du ou des futurs inserts métalliques. Cette irradiation UV peut par exemple être réalisée au moyen d'un aligneur de masques pour photolithographie (non représenté) ayant ses pics d'intensité à 365 et 410 nm. L'ampleur de l'irradiation dépend de l'épaisseur de la résine. Elle est typiquement de 200 à 1'000 mJ/cm² mesurée à une longueur d'onde de 365 nm. Le cas échéant, une étape de recuit de la couche (post-bake) peut être nécessaire pour compléter la polymérisation induite par l'irradiation UV. Avec un photoresist positif comme celui utilisé dans le présent exemple, l'étape de recuit est de préférence effectuée entre 90 et 95°C durant quelques minutes. Les zones insolées 3a pourront ultérieurement être dissoutes en utilisant un liquide de développement adéquat. Par contre les zones non insolées (polymérisées) 3b deviennent insensibles à une grande majorité des liquides de développement.

L'étape suivante du procédé (figure 4) consiste à développer la première couche de résine photosensible 3. Dans le présent exemple, le photoresist utilisé est positif. Dans ces conditions, développer le photoresist revient à l'attaquer chimiquement, de manière à dissoudre les zones insolées 3a et à faire apparaître par endroit la couche conductrice 2 du substrat 1. On comprendra toutefois que, dans le cas d'un photoresist négatif, ce sont les zones non insolées 3b qui sont dissoutes. L'homme du métier saura choisir un liquide de développement adéquat pour l'étape de développement du photoresist sur la base des indications du fabricant de la résine photosensible. Selon une variante avantageuse, il est possible de parachever l'étape de développement par une brève exposition à un plasma de manière à bien nettoyer le moule en résine 3b et à en activer la surface en prévision de l'étape suivante. L'activation des surfaces permet en effet d'améliorer l'amorçage ainsi que la régularité d'un dépôt galvanique.

L'étape suivante du procédé (figure 5) consiste à électroformer le premier élément 5 (ou, autrement dit, le ou les inserts) par dépôt galvanique d'un premier métal dans les ouvertures du premier moule en résine 3b. Dans le présent exemple, les inserts sont réalisés en or. Toutefois, l'homme du métier comprendra que beaucoup d'autres métaux pourraient être utilisés. Pour des inserts dont la fonction est décorative, on peut citer en particulier le platine, le palladium, l'argent et le rhodium. L'homme du métier saura déterminer les conditions pour le dépôt galvanique, notamment la composition du bain, la géométrie du système, les tensions et densités de courant, en fonction du métal ou de l'alliage à déposer. Il pourra se référer par exemple à Di Bari G. A. « electroforming » Electroplating Engineering Handbook 4th Edition, sous la direction de L. J. Durney, publié par Van Nostrand Reinhold Company Inc. N.Y. USA 1984.

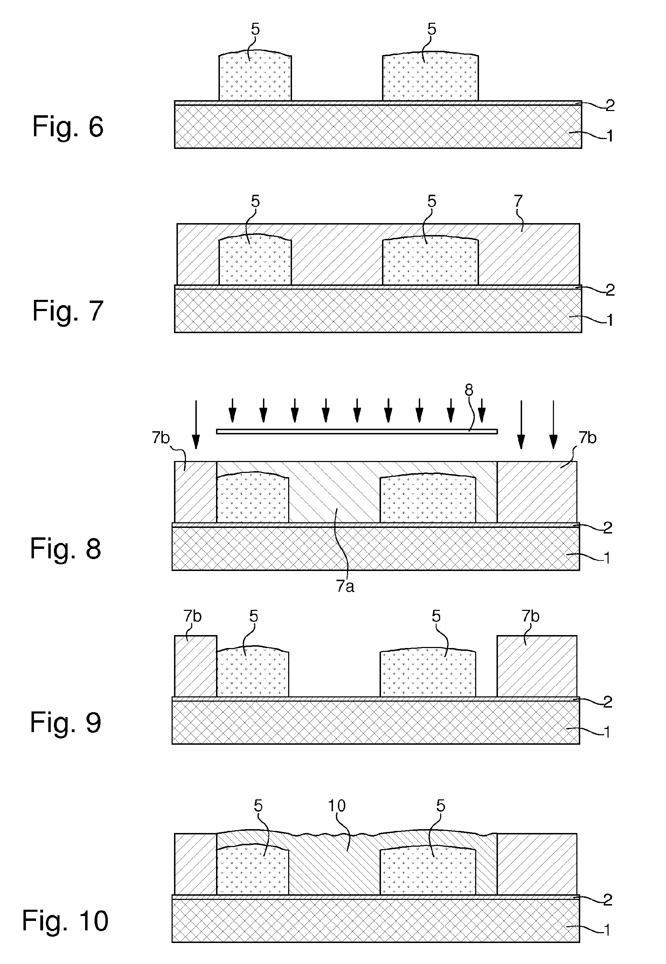

Selon une première variante du procédé de la présente invention, l'étape suivante du procédé (figure 6) consiste à démouler le premier élément 5 par élimination de la résine polymérisée constituant le premier moule 3b. L'homme du métier saura choisir un bain approprié pour éliminer le moule en résine 3b sans attaquer, ni le métal constituant les éléments électroformés 5, ni le métal de la couche d'amorçage 2. Dans certains cas, pour éliminer complètement la résine, il peut être nécessaire de compléter ou de remplacer l'utilisation de réactifs en solution par le recours à une attaque par un plasma. C'est en général le cas notamment lorsque le moule est réalisé en SU-8.

Selon une seconde variante (non représentée sur les figures), au lieu de démouler le premier élément 5, on dépose par vaporisation sous vide une couche de métal, dite couche d'accrochage, sur la surface formée par le dessus du premier moule 3b et de l'élément 5 qui vient d'être formé. La fonction de la couche d'accrochage est de former une nouvelle surface conductrice d'amorçage en vue de l'électroformage ultérieur du deuxième élément.

L'étape suivante du procédé (figure 7) consiste à recouvrir la surface conductrice 2 et le premier élément 5 (ou alternativement recouvrir la nouvelle surface conductrice) d'une nouvelle couche de résine photosensible 7. La résine utilisée est de préférence la résine (déjà mentionnée) à base d'époxy octofonctionnelle disponible chez MicroChem sous la référence SU-8. Cette résine comprend également un photoinitiateur choisi parmi les sels de triarylsulfonium tels que ceux décrits dans le brevet US 4,058,401. Cette résine constitue un photorésist négatif qui est conçu pour polymériser sous l'action d'un rayonnement UV. L'homme du métier comprendra toutefois qu'une autre résine photosensible (positive ou négative) pourrait être utilisée à la place du SU-8 sans sortir du cadre de la présente invention.

La résine 7 peut être déposée sur la couche d'amorçage 2 à l'aide de toute technique connue de l'homme du métier ; par exemple, à la tournette (spin coating), par application au cylindre, ou encore par laminage lorsqu'il s'agit d'une résine en film, etc. L'épaisseur de la couche de résine photosensible 3 est typiquement comprise entre 150 et 600 microns. Selon l'épaisseur et la technique utilisée, la résine pourra être déposée en une ou plusieurs fois.

L'étape suivante du procédé (figure 8) consiste à irradier la nouvelle couche de résine photosensible au moyen d'un rayonnement UV à travers un masque 8 correspondant à l'empreinte désirée. Avec un photoresist négatif comme le SU-8, les zones non insolées 7a pourront ultérieurement être dissoutes en utilisant un liquide de développement adéquat. Par contre les zones insolées (polymérisées) 7b deviennent insensibles à une grande majorité des liquides de développement. Le cas échéant, une étape de recuit de la couche (post-bake) peut être nécessaire pour compléter la polymérisation induite par l'irradiation UV Avec un photoresist négatif comme le SU-8, l'étape de recuit est de préférence effectuée entre 90 et 95°C pour une durée allant de quelques minutes à quelques heures.

L'étape suivante du procédé (figure 9) consiste à développer la nouvelle couche de résine photosensible, c'est à dire à dissoudre les zones non insolées de celle-ci, de manière à former un nouveau moule en résine 7b. L'ouverture du nouveau moule laisse apparaître le premier élément 5 et la surface conductrice 2 du substrat. Comme à l'étape (d), il est possible de parachever l'étape de développement par une brève exposition à un plasma de manière à bien nettoyer le moule en résine et à en activer la surface en prévision de l'étape suivante.

L'étape suivante du procédé (figure 10) consiste à électroformer le deuxième élément 10 par dépôt galvanique d'un deuxième métal dans l'ouverture ou les ouvertures du nouveau moule en résine 7b. Par un choix judicieux des deux métaux utilisés dans le procédé, l'homme du métier pourra donner à la pièce bimétal les propriétés esthétiques ou mécaniques qu'il recherche. Par métaux dans ce contexte sont bien entendu compris les alliages métalliques. Typiquement, le deuxième métal sera choisi parmi l'ensemble comprenant le Nickel, le cuivre, l'or, l'argent, le nickel-fer et le nickel-phosphore.

L'homme du métier comprendra que la présente invention ne se limite pas à des applications décoratives. La fonction d'un premier élément en un premier métal qui est inséré dans un deuxième élément en un deuxième métal peut également être une fonction mécanique ou tribologique. A titre d'exemple, il est possible de réaliser des aiguilles de montre en métal qui comprennent un insert fait d'un matériau très dense situé à l'arrière de l'aiguille. Cet insert servant de contrepoids à l'index de l'aiguille. Selon un mode de réalisation particulier, une aiguille en nickel (densité 8,9) pourrait par exemple comporter un gros insert en or (densité 19,3) comme contrepoids. Précisons qu'un insert destiné à servir de contrepoids devrait de préférence avoir une épaisseur importante (plus de 100 microns environ) de manière à ce que sont poids soit suffisant pour avoir l'effet recherché.

Une fois le deuxième élément 10 électroformé, il peut être nécessaire de mettre à niveau sa face supérieure par des opérations de rodage et de polissage. Selon la solidité du substrat, cette opération de mise à niveau peut se faire immédiatement après le dépôt galvanique, avant la séparation de la pièce bimétal d'avec le substrat.

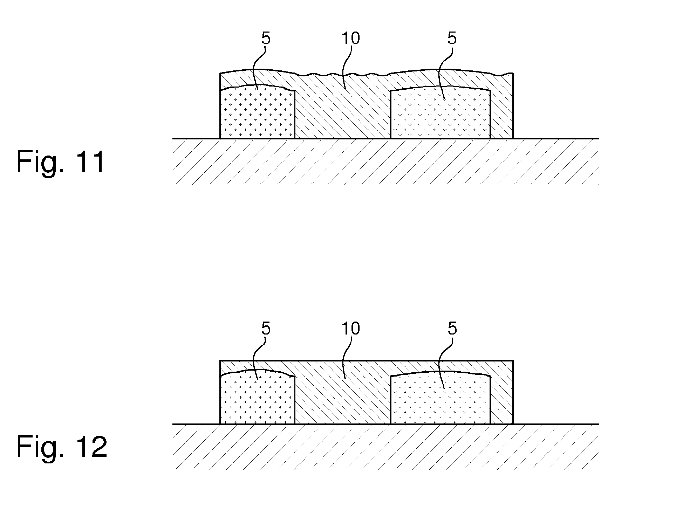

L'étape suivante du procédé (figure 11) consiste à démouler le deuxième élément par séparation du substrat et élimination de la résine photosensible constituant le nouveau moule. Selon une variante avantageuse, on commence par détacher du substrat l'ensemble formé par le moule en résine et la pièce bimétal électroformée au cours des étapes précédentes. Toutefois, l'homme du métier comprendra que selon une variante alternative, il est possible d'éliminer d'abord la résine polymérisée formant le moule, avant de séparer la pièce bimétal du substrat.

Lorsque le substrat est constitué d'un « wafer », ou plaque, en silicium, il est possible de l'éliminer cette dernière par dissolution dans un bain d'hydroxyde de potassium (KOH) ou de TMAH. Dans le cas où le substrat est formé par une plaque en verre ou en céramique, il n'est pas possible de dissoudre la plaque. La séparation du substrat doit donc se faire au niveau de la couche sacrificielle. Selon la nature de la couche sacrificielle formée au début du procédé, la séparation du substrat d'avec la pièce bimétal peut être obtenue par dissolution de la couche sacrificielle (par exemple, à l'aide de KOH si la couche est en aluminium) ou, au contraire, sans agent chimique, par un simple délaminage au niveau de la couche sacrificielle. Selon les matériaux utilisés, il est également possible de se passer de couche sacrificielle. C'est le cas notamment lorsque le substrat est une plaquette métallique massive. Une telle plaque peut en principe être détachée de la pièce bimétal et du moule en résine simplement par délaminage.

Une fois que la pièce bimétal et le moule en résine ont été détachés du substrat, il faut encore éliminer le moule en résine polymérisée pour libérer la pièce métallique.

Dans l'exemple qui fait l'objet de la présente description, le procédé comporte encore une dernière étape (figure 12) qui consiste à mettre à niveau la partie supérieure de la pièce bimétal par des opérations de rodage et de polissage.

On comprendra en outre que diverses modifications et/ou améliorations évidentes pour un homme du métier peuvent être apportées au mode de mise en oeuvre qui fait l'objet de la présente description sans sortir du cadre de la présente invention définie par les revendications annexées.

## Revendications

1. Procédé de fabrication de micro-pièces métalliques comprenant au moins un premier élément (5) réalisé en un premier métal inséré dans un deuxième élément (10) réalisé en un deuxième métal, le premier et le deuxième élément étant réalisés par photolithographie UV et dépôt galvanique, **caractérisé en ce que** le procédé comprend les étapes consistant à :
a) se munir d'un substrat (1, 2) comportant une surface conductrice d'amorçage (2) ;
b) recouvrir la surface conductrice d'amorçage (2) d'une première couche de résine photosensible (3) ;
c) irradier la première couche de résine photosensible (3) à travers un masque (4) correspondant à l'empreinte désirée ;
d) développer la première couche de résine photosensible (3) de manière à creuser dans celle-ci des ouvertures et à obtenir ainsi un premier moule en résine (3b), les ouvertures dans le premier moule de résine laissant apparaître la surface conductrice d'amorçage (2) du substrat ;
e) électroformer le premier élément (5) par dépôt galvanique d'un premier métal dans les ouvertures du premier moule (3b) en résine ;
f) exposer la surface conductrice d'amorçage (2) du substrat en éliminant la résine photosensible constituant le premier moule (3b) autour du premier élément (5) ou, alternativement, déposer une fine couche de métal sur la première couche en résine photosensible de manière à former une nouvelle surface conductrice d'amorçage ;
g) recouvrir la surface conductrice d'amorçage (2) exposée, ainsi que le premier élément (5), d'une nouvelle couche de résine photosensible (7) ;
h) irradier la nouvelle couche de résine photosensible (7) à travers un masque (8) correspondant à l'empreinte désirée ;
i) développer la nouvelle couche de résine photosensible (7) de manière à creuser dans celle-ci des ouvertures et à obtenir ainsi un nouveau moule (7b) en résine, les ouvertures dans le nouveau moule de résine laissant apparaître le premier élément (5), ainsi que la surface conductrice d'amorçage (2) du substrat ou la nouvelle surface conductrice d'amorçage.
j) électroformer le deuxième élément (10) par dépôt galvanique d'un deuxième métal dans les ouvertures du nouveau moule (7b) en résine ;
k) séparer le premier (5) et le deuxième élément (10) du substrat (1).

2. Procédé de fabrication selon la revendication 1, **caractérisé en ce que** l'étape f) consiste à exposer la surface conductrice d'amorçage (2) du substrat (1) en éliminant la résine photosensible constituant le premier moule (3b) autour du premier élément (5).

3. Procédé de fabrication selon la revendication 1, **caractérisé en ce que** l'étape f) consiste à déposer une fine couche de métal sur la première couche en résine photosensible de manière à former une nouvelle surface conductrice d'amorçage.

4. Procédé de fabrication selon la revendication 1, 2 ou 3 **caractérisé en ce qu'**il comprend après l'étape j) une étape m) consistant à éliminer la résine photosensible constituant le nouveau moule (7b).

5. Procédé de fabrication selon la revendication 4, **caractérisé en ce que** l'étape m) consistant à éliminer la résine photosensible constituant le nouveau moule (7b), est réalisée après l'étape k) de séparation du deuxième élément (10) d'avec le substrat (1).

6. Procédé selon l'une des revendications précédentes, **caractérisé en ce qu'**il comprend après l'étape j) une étape n) consistant à mettre à niveau la pièce bimétal (5, 10).

7. Procédé selon la revendication 6, **caractérisé en ce que** l'étape n) consistant à mettre à niveau la pièce bimétal, est réalisée après l'étape k) de séparation du premier (5) et du deuxième élément (10) d'avec le substrat (1).

8. Procédé de fabrication selon les revendications 4 et 6, **caractérisé en ce que** l'étape n) consistant à mettre à niveau la pièce bimétal, est réalisée après l'étape m) de d'élimination de la résine photosensible constituant le nouveau moule (7b).

9. Procédé de fabrication selon l'une des revendications précédentes, **caractérisé en ce que** la surface conductrice d'amorçage (2) est formée d'un empilement de couches de chrome et d'or.
